# EUROPÄISCHE PATENTSCHRIFT

(11) **EP 1 271 628 B1**
(45) Veröffentlichungstag und Bekanntmachung des Hinweises auf die Patenterteilung: **25.10.2006**
(21) Anmeldenummer: 02012665.2
(22) Anmeldetag: 07.06.2002
(51) Int. Cl.: H01L 21/265, H01L 21/762

(54) **Verfahren zur Ausbildung eines Silizium-Halbleiterkörpers**
Method of forming a silcon body
Methodé de formation d'un corps de silicium

(30) Priorität: 29.06.2001 DE 10131704
(43) Veröffentlichungstag der Anmeldung: 02.01.2003
(73) Patentinhaber: ATMEL Germany GmbH, 74072 Heilbronn (DE)
(72) Erfinder: Bromberger, Christoph, 74211 Leingarten (DE); Dietz, Franz, 74081 Heilbronn (DE); Dudek, Volker, Dr., 74336 Brackenheim (DE); Graf, Michael, Dr., 71229 Leonberg (DE); Herrfurth, J., 74080 Heilbronn (DE); Klaussner, Manfred, 74080 Heilbronn (DE)

(56) Entgegenhaltungen:
- EP-A- 0 547 711
- EP-A- 0 905 784
- US-A- 4 975 384
- US-A- 5 387 534
- US-A- 5 466 616
- US-A- 5 780 353
- US-B1- 6 184 566

## Beschreibung

Die vorliegende Erfindung betrifft ein Verfahren zur Ausbildung eines Silizium-Halbleiterkörpers, gemäß dem Oberbegriff des Patentanspruchs 1.

Ein Verfahren zur Ausbildung eines Silizium-Halbleiterkörpers ist aus der Druckschrift US 5 466 616 bekannt. Dabei wird die Oberfläche eines Halbleiterkörpers mittels einer Maske dotiert und nach einem Temperaturschritts durch eine anisotrope Trockenätzung eine Grabenstruktur erzeugt, wobei die Dotierung im Bodenbereich des Grabens durch den Ätzschritt innerhalb der Maskenöffnung entfernt wird. Bei der nachfolgenden Naßätzung eines V-Graben wirken die seitlich hochdotierten Gebiete als Ätzstopp, d.h. sie verhindern die Unterätzung der mittels der Maske definierten Öffnung. Dabei wird eine grabenförmige Struktur genutzt, um einen P-Dotierstoff einzubringen und diesen bis unter das Gate-Oxid des N-LDMOS-Transistors einzudiffundieren. Für diesen Zweck ist die Dotierstoffverteilung symmetrisch bezüglich der Mitte der grabenförmigen Struktur ausgebildet.

Ein weiteres Verfahren zur Ausbildung eines Silizium-Halbleiterkörpers ist aus der Druckschrift EP 176 778 bekannt. Hierbei wird mittels kleinen zusätzlichen Öffnungen im Randbereich einer Implantationsmaske, deren Größe und Anzahl von der Entfernung von der eigentlichen Maskenöffnung abhängen, in der Randbereich der Maske ein Dotierprofil erzeugt, das seitlich flach ausläuft und sich der Oberfläche des Halbleiterkörpers allmählich annähert, um damit die Durchbruchspannung von Halbleiterbauelementen zu erhöhen. Nachteilig bei dem Verfahren ist, daß die erzeugten flach auslaufenden Zonen einen erheblichen Platzbedarf benötigen und dies für eine platzsparende Integration hinderlich ist. Ferner sind umfangreiche Prozess- und Devicesimulationen notwendig, um die genaue Zahl, Lage und Größe der Öffnungen in den Dotierstoffmasken zu berechnen.

Aus der US 5,387,534 ist die Herstellung von SONOS-memory-cell-arrays bekannt. Diese weisen grabenförmige geätzte Strukturen auf, die Transistoren isolieren. Die grabenförmigen Strukturen weisen in den Seitenwänden bezüglich der Mitte der grabenförmigen Struktur eine symmetrische Dotierung auf.

Aus der EP 0 905 784 A2 ist eine Trench-capaciter-DRAM-Zelle und deren Herstellungsverfahren bekannt. Dabei ist die Dotierung der Seitenwände bezüglich der Mitte einer grabenförmigen Struktur der Zelle symmetrisch.

Aus der US 6,184,566 B1 ist ein Verfahren zur Isolation von Halbleiterbauelementen auf einem Halbleitersubstrat bekannt. Zur Isolation wird eine grabenförmige Struktur geätzt und in diese Dotierstoffe eingebracht. Die Dotierung der Seitenwände bezüglich der Mitte der grabenförmigen Struktur ist symmetrisch.

Ein Ziel in der Entwicklung auf dem Gebiet der Halbleitertechnologie ist es, platzsparende Strukturen zu entwickeln, die auch bei höheren Sperrspannungen niedrige Feldstärken aufweisen, um eine Generation von Ladungsträgern, die zu einem Durchbruch innerhalb der Siliziumschicht führt, zu vermeiden. Ein weiteres Ziel ist es, durch die Vermeidung oder Verkürzung von Hochtemperaturprozessen das thermische Budget im Herstellungsprozess von Halbleiterstrukturen weiter zu senken, um damit flachere Dotierstoffprofile innerhalb eines Halbleiterkörpers zu erzeugen.

Der vorliegenden Erfindung liegt die Aufgabe zu Grunde, ein Verfahren anzugeben, mit dem sich ein Silizium-Halbleiterkörper ausbilden lässt, um auf kleiner Fläche niedrige Feldstärken zu erzielen und das sich einfach und kostengünstig durchführen läßt.

Die genannte Aufgabe wird durch die Merkmale des Patentanspruches 1 gelöst. Günstige Weiterbildungen und Ausgestaltungsformen sind Gegenstand von Unteransprüchen.

Das Verfahren der Erfindung besteht darin, dass in einem ersten Prozessschritt in einen Silizium-Halbleiterköper mittels einer Dotierstoffmaske ein erster Dotierstoff eingebracht wird und hiernach in einem zweiten Prozessschritt wenigstens in einem Bereich der Maskenöffnung mittels eines anisotropen Siliziumätzschritts eine grabenförmige Struktur mit Seitenwänden erzeugt wird.

Das Wesen der Erfindung ist, dass in einem dritten Prozessschritt ein zweiter Dotierstoff derart eingebracht wird, dass die Dotierstoffkonzentration in den Seitenwänden der grabenförmigen Struktur unterschiedlich ist.

In einer Weiterbildung des Verfahrens wird, sofern im ersten Prozeßschritt eine senkrechte Einbringung des ersten Dotierstoffs erfolgt, vor dem zweiten Prozeßschritt ein Diffusionsschritt durchgeführt, um mittels einer lateralen Unterdiffusion unter die Maskenränder eine vollständige Entfernung des ersten Dotierstoffs bei der nachfolgenden Siliziumätzung zu vermeiden. Wird im ersten Prozeßschritt dagegen der erste Dotierstoff bereits lateral unter die Ränder der Maske eingebracht, ist es vorteilhaft eine Diffusion bzw. Aktivierung des nach der Siliziumätzung in den Seitenwänden der grabenförmigen Struktur verbleibenden ersten Dotierstoffs mit einem späteren Temperaturschritt durchzuführen.

In einer anderen Weiterbildung des Verfahrens ist es vorteilhaft, in dem dritten Prozeßschritt den zweiten Dotierstoff räumlich selektiv, vorzugsweise in den Bodenbereich der grabenförmigen Struktur, einzubringen. Dies läßt sich durchführen, indem eine oder mehrere Seitenwände der grabenförmigen Struktur mit einer Schutzschicht belegt werden oder der zweite Dotierstoff anisotrop eingebracht wird.

Ein Vorteil des Verfahrens liegt darin, daß sich der Bodenbereich der grabenförmigen Struktur unabhängig von den Seitenwänden dotieren läßt. Ferner lassen sich in die einzelnen Seitenwände der grabenförmigen Struktur unterschiedliche Polaritäten und Arten von Dotierstoffen einbringen, indem vor der Einbringung des jeweiligen Dotierstoffes ein oder mehrere Seitenwände, beispielsweise mittels einer Molekularstrahlanlage mit einer Schutzschicht belegt werden. Sofern keine Schutzschichten erzeugt werden, lässt sich durch die räumlich selektive Einbringung des zweiten Dotierstoffes im dritten Prozeßschritt die Konzentration und die Polarität der Dotierung in den einzelnen Seitenwänden unabhängig einstellen. Insbesondere lassen sich von den einzelnen Seitenwänden zu dem Bodenbereich der grabenförmigen Struktur unterschiedliche vertikale Konzentrationsgradienten herstellen. Ferner lassen sich bei der Dotierung der einzelnen Seitenwände und des Bodenbereichs der grabenförmigen Struktur die Polarität der Dotierstoffe ändern. Weiterhin vorteilhaft ist es, das Dotierstoffprofil der grabenförmigen Struktur an die elektrischen Anforderungen einer integrierten Schaltung anzupassen, um beispielsweise bei hohen Sperrspannungen durch die vertikale Ableitung des Feldgradienten bei geringem Flächenverbrauch niedrige Feldstärken zu erreichen, und damit die Integrationsdichte bei der Herstellung von integrierten Schaltungen zu steigern. Insbesondere bei Anwendungen im Bereich der Sperrspannung, ist es dabei vorteilhaft die grabenförmige Struktur mittels eines isolierenden Materials wie beispielsweise Oxid und oder Nitrid aufzufüllen.

In einer Weiterbildung des Verfahrens wird der Bodenbereich der grabenförmigen Struktur trotz isotroper Einbringung des zweiten Dotierstoffs selektiv dotiert, indem alle Seitenwände vor dem dritten Prozeßschritt mit einer Schutzschicht, vorzugsweise mittels eines Oxids und oder Nitrids, belegt werden. Ferner läßt sich durch die Belegung aller Seitenwände, beispielsweise mittels eines Abscheidungs- oder Oxidationsprozesses die Prozessführung vereinfachen, wobei sich die Dicke der Schutzschicht aus der Reichweite / Diffusionslänge des Dotierstoffs in der Schutzschicht bestimmt.

In einer anderen Weiterbildung des Verfahrens ist es vorteilhaft, die Schutzschicht an den Seitenwänden selbstjustierend, beispielsweise mittels eines Spacerprozesses zu erzeugen. Da beim Spacerprozeß die Ausgangsschicht, wie beispielsweise Nitrid und oder Oxid, durch eine Abscheidung erzeugt wird, lassen sich insbesondere nicht senkrechte Seitenwände mit einer genügend dicken Schutzschicht belegen, ohne daß der Wafer einer hohen Temperaturbelastung ausgesetzt wird. Ferner läßt sich die erforderliche Mindestdicke der Schutzschicht mittels den Prozessparametern bei der Abscheidung, wie beispielsweise Konformität und Schichtdicke, in Verbindung mit den Parametern der Ätzung, wie Selektivität von Oxid zu Silizium und Ätzdauer, leicht einstellen. Ferner läßt sich mit der Schutzschicht als Maske eine weiterer Siliziumätzschritt durchführen.

In einer anderen Weiterbildung des Verfahrens werden der erste und der zweite Dotierstoff mittels einer Implantation eingebracht, wobei die Einbringung vorzugsweise mit einem zu der Oberfläche des Halbleiterkörpers senkrechten Implantationswinkel durchgeführt wird. Sofern die Seitenwände der grabenförmigen Struktur senkrecht sind, läßt sich damit eine selektive Dotierung des Bodenbereichs durchführen, ohne daß die Seitenwände mit einer Schutzschicht belegt werden. Zur Erhöhung der Prozesssicherheit bei der Implantation, läßt sich jedoch zweckmäßigerweise auch das vor einer Implantation im Bodenbereich zur Unterdrükkung einer möglichen Crosskontamination gebildete dünne Streuoxid, von beispielsweise 100 A, als Schutzschicht für die Seitenwände benützen, um den Dotierstoffeintrag an den Seitenwänden, beispielsweise bei einer eventuellen Fehljustierung des Wafers, zu behindern.

In einer anderen Weiterbildung des Verfahren wird im ersten und dritten Prozessschritt ein Dotierstoff von gleicher Polarität, jedoch von unterschiedlicher Konzentration implantiert, um einen vertikalen Dotierstoffgradient in der Seitenwand zu erzeugen, wobei es vorteilhaft ist, die Konzentration des Dotierstoffs im ersten Prozessschritt kleiner als die des dritten Prozessschritts zu wählen. Wird ferner, insbesondere im dritten Prozeßschritt, die Implantation unter zwei Winkeln durchgeführt, wobei ein Implantationswinkel vorzugsweise senkrecht ist, läßt sich auf einfache Weise ein Konzentrationsgradient zwischen den einzelnen Seitenwänden erzeugen.

In einer anderen Weiterbildung des Verfanrens wird im ersten Prozessschritt im Vergleich zu dem dritten Prozessschritt die Polarität des Dotierstoffs gewechselt, um einen oder mehrere PN-Übergänge entweder zwischen den Seitenwänden und dem Bodenbereich der Struktur oder zwischen den einzelnen Seitenwänden herzustellen.

In einer anderen Weiterbildung des Verfahrens ist es besonders vorteilhaft, wenn das Verhältnis von Grabenbreite zu Grabentiefe größer als 0.5 ist, da sich die Herstellung der grabenförmigen Struktur mit Standardprozessen wie eines "shallow trench isolation"-Prozess (STI) durchführen läßt. Weiterhin ist es vorteilhaft, vor dem dritten Prozessschritt (Implantation) einen anisotropen Siliziumätzschritt unter Verwendung der Schutzschicht als Ätzmaske durchzuführen. Damit lässt sich auf besonders einfache Weise die Tiefe der Grabenstruktur vor dem dritten Prozeßschritt (der zweiten Implantation) erhöhen und zwischen der ersten Dotierung und der zweiten Dotierung ein Bereich in der grabenförmigen Struktur erzeugen, indem sich die Konzentration der eingebrachten Dotierstoffe nicht summieren.

In einer anderen Weiterbildung des Verfahrens wird nach dem dritten Prozessschritt ein oder mehrere der Prozessschritte 1 bis 3 mehrfach durchgeführt, um beispielsweise mehrfach PN-Übergänge, wie NPN- oder PNP- oder Thyristorstrukturen in der grabenförmigen Struktur, zu erzeugen.

Grabenförmige Strukturen, die beispielsweise mit Oxid gefüllt sind, lassen sich vorteilhaft in Bauelemente integrieren, um beispielsweise mittels den frei wählbaren Seitenwand- und Bodenprofilen die bei hohen Spannungen auftretenden Feldstärkespitzen auf kleiner Fläche zu verringern. Ferner läßt sich die Isolation zwischen benachbarten Halbleiterbauelementen bei kleinem Flächenverbrauch verbessern. Eine weitere Anwendung besteht beispielsweise bei Wafern mit isolierender Zwischenschicht darin, daß mittels des vertikalen Dotierprofils an der Seitenwand in Verbindung der Dotierung des Bodenbereichs und der verbleibenden Dicke des zwischen der isolierenden Zwischenschicht und des Bodens der grabenförmigen Struktur eine vergrabene Widerstandsstruktur erzeugen läßt.

Das erfindungsgemäße Verfahren soll nachfolgend anhand von schematisierten Ausführungsbeispielen im Zusammenhang mit den Zeichnungen erläutert werden. Es zeigen die
- Fig. 1a.: einen Querschnitt einer grabenförmigen Struktur mit senkrechten Seitenwänden, und
- Fig. 1b: eine Weiterentwicklung der grabenförmigen Struktur von Figur 1a mit einem vertikalem Dotierprofil in den Seitenwänden, und
- Fig. 2a: einen Querschnitt einer grabenförmigen Struktur mit einer in der linken Seitenwand gegenüber der rechten Seitenwand unterschiedlich hohen Dotierstoffkonzentration, und
- Fig. 2b: eine Weiterentwicklung der grabenförmigen Struktur von Figur 2a, mit unterschiedlich geneigten Seitenwänden.

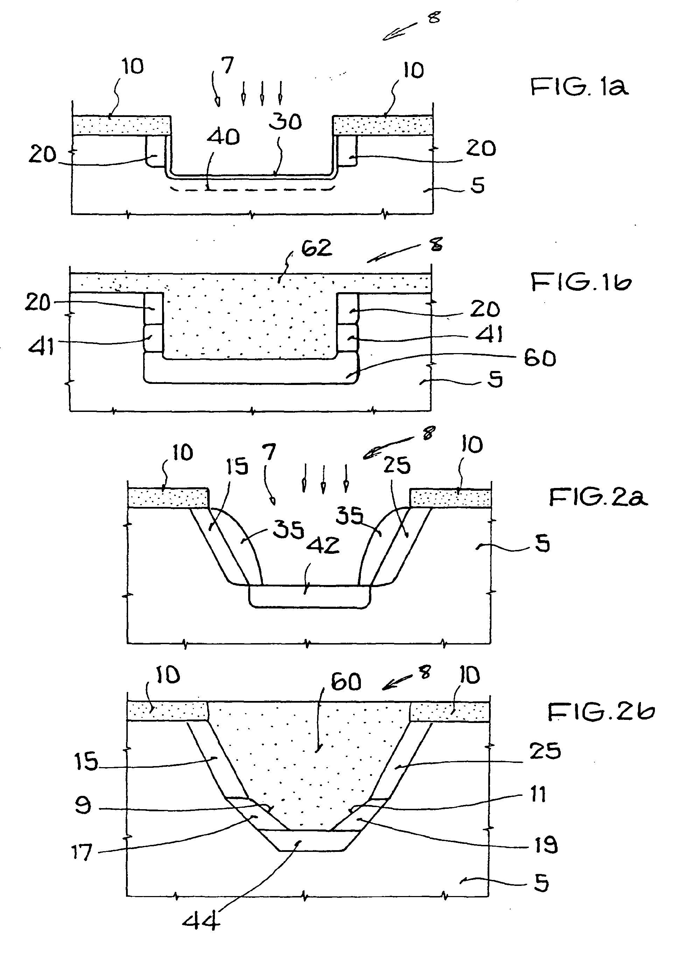

Die Figur 1a zeigt einen Querschnitt eines Halbleiterkörpers 5 aus Silizium, der nachfolgend als Wafer 5 bezeichnet wird, der eine grabenförmige Struktur aufweist. Eine derartige Anordnung lässt sich beispielsweise zur Isolation von benachbarten Bauelementen auf dem Wafer verwenden.

Im Folgenden wird die Abbildung näher erläutert, wobei die Strukturierung des Wafers mit einer Prozeßfolge, die nicht abgebildet ist, durchgeführt wird. Der Wafer weist eine niedrige Dotierung, die beispielsweise bei 20 Ohm/cm liegt, von einer ersten Polarität auf. Ausgangspunkt für die Strukturierung bildet eine Schutzschicht 10, die beispielsweise aus einer Oxid/Nitrid Schicht besteht, in der mittels eines Maskenschritts eine Öffnung 7 erzeugt wird. In einem nachfolgenden Prozeßschritt wird mittels einer Implantation ein Dotierstoff von einer zweiten Polarität implantiert und mittels eines thermischen Prozesses eindiffundiert. In einem nachfolgenden Prozeßschritt wird in der Öffnung 7 mittels einer anisotropen Silizium-Ätzung eine grabenförmige Struktur 8 erzeugt, wobei die Tiefe der Ätzung die Eindringtiefe der Dotierung übersteigt. Durch die laterale Unterdiffusion in Verbindung mit der Silizium-Ätzung verbleibt in der linken Seitenwand und in der rechten Seitenwand ein erster und ein zweiter Bereich 20, die einen Teil des Dotierstoffs der ersten Polarität enthalten.

Eine weitere vorteilhafte Möglichkeit die dotierten Bereiche 20 zu erzeugen, besteht darin, daß mittels einer Implantation bei unterschiedlichen Winkeln, beispielsweise bis zu 60 Grad, der Dotierstoff bei der Implantation lateral unter die Maskenrändern eingebracht wird. Damit verbleibt auch ohne Diffusionsschritt nach dem Siliziumätzschritt genügend Dotierstoff in den Seitenwänden der grabenförmigen Struktur 8.
In einem nachfolgenden Prozeßschritt werden die Seitenwände und der Bodenbereich mit einer Schicht 30, die beispielsweise aus einem thermisch erzeugten Oxid besteht und im Bereich von 100 A liegt, belegt. Während das Oxid an den Seitenwänden im nachfolgenden Implantationsschritt, der in der Abbildung dargestellt ist, als Schutzschicht dient, wirkt es im Bodenbereich als Streuoxid und verhindert eine Crosskontamination des Bodenbereichs der grabenförmigen Struktur 8. In dem Implantationsschritt wird ein Dotierstoff einer zweiten Polarität mit einer Konzentration, die unterhalb der Konzentration der ersten Dotierstoffeinbringung liegt, in einen Bereich 40 implantiert. Da die Implantation senkrecht zur Waferoberfläche erfolgt, wird nur der Bodenbereich dotiert.

Das Querschnittsbild der Figur 1b zeigt eine Weiterentwicklung der in Figur 1a dargestellten grabenförmigen Struktur 8, wobei im Folgenden die weiteren Prozessschritte erläutert werden, die zur Erzeugung der dargestellten Struktur durchgeführt werden. In einem Diffusionsschritt wird der Dotierstoff des Bereichs 40 lateral in einen Bereich 41 sowie in den Bodenbereich eindiffundiert, wobei mittels einer nachfolgenden anisotropen Silizium-Ätzung der Dotierstoff im Bodenbereich vollständig entfernt wird und damit in der linken und rechten Seitenwand der eingebrachte Dotierstoff ausschließlich in den Bereichen 41 verbleibt. In einem nachfolgenden Prozeßschritt wird ein Streuoxid erzeugt, welches an den Seitenwänden als Schutzschicht wirkt. In einem nachfolgenden Prozessschritt wird mittels einer Implantation ein weiterer Dotierstoff von der zweiten Polarität unter einem senkrechten Winkel eingebracht, wobei die Konzentration unterhalb der Konzentration des zweiten Implantationsschrittes liegt. In einem nachfolgenden Diffusionsschritt wird der Dotierstoff in einen Bereich 60 eindiffundiert. In einem weiteren nachfolgenden Prozeßschritt wird die Struktur mit einem Oxid 62 aufgefüllt.

Durch die Mehrfachanwendung der Prozessfolge aus Ätzung und Implantation wird in der Seitenwand der grabenförmigen Struktur 8 ein vertikales Dotierprofil eingestellt, das zum Boden der grabenförmigen Struktur eine abnehmende Konzentration aufweist. Durch die unabhängige Wahl des Dotierstoffs zwischen dem Bodenbereich und den Seitenwänden d.h. die Polarität und die Konzentration des Dotierstoffs in den Seitenwänden, lassen sich auch entgegengesetzte Konzentrationsgradienten, d.h. der Bodenbereich weist eine höhere Konzentration als die Seitenwände auf, einstellen. Mittels den Prozessparametern, wie beispielsweise Ätztiefe, Dosis und Energie lassen sich sanfte Konzentrationsübergänge ohne eine hohe Temperaturbelastung erzeugen. Bei einer anliegenden Sperrspannung lassen sich damit Feldstärkespitzen vermeiden. Ferner lassen sich durch das Wechseln der Polarität des Dotierstoffs zwischen den einzelnen Implantationsschritten mehrfach PN-Übergänge, wie beispielsweise PNP, NPN oder Thyristorstrukturen, herstellen. Sofern in den einzelnen Implantationsschritten senkrecht implantiert und im Bodenbereich kein Streuoxid benötigt wird, erübrigt sich an den Seitenwänden die dünne Schutzschicht aus Oxid, d.h. die thermische Belastung des Wafers läßt sich weiter senken.

Das in Figur 2a dargestellte Querschnittsbild zeigt einen Wafer mit einer grabenförmigen Struktur 8, wie sie beispielsweise mit einer STI-Ätzung erzeugt wird. Dabei läßt sich durch die während der Trockenätzung des Siliziums zunehmende Polymerisierung der Seitenwand, die Öffnung der Struktur mit zunehmender Ätztiefe kontinuierlich verkleinern. Das Aspektverhältnis der grabenförmigen Struktur 8 liegt vorzugsweise oberhalb von 0.5.

Im Folgenden wird die Abbildung näher erläutert, wobei die Strukturierung des Wafers mit einer Prozeßfolge, die nicht abgebildet ist, durchgeführt wird. Der Wafer weist eine niedrige Dotierung, dessen spezifischer Widerstand beispielsweise bei 20 Ohm/cm liegt von einer ersten Polarität auf. Ausgangspunkt für die Strukturierung bildet eine Schutzschicht 10, in der mittels eines Maskenschritts eine Öffnung 7 erzeugt wird. In einem nachfolgenden Prozeßschritt wird mittels einer Implantation unter einem Winkel (Tilt), von beispielsweise 45 Grad, ein Dotierstoff von einer zweiten Polarität implantiert und mittels eines thermischen Prozesses eindiffundiert, wobei der Tiltwinkel so gewählt wird, daß die Implantation von links nach rechts erfolgt. In einem nachfolgenden Prozeßschritt wird mittels einer anisotropen Silizium-Ätzung in der Öffnung 7 eine grabenförmige Struktur 8 mit schrägen Seitenwänden erzeugt, wobei die Tiefe der Ätzung die Eindringtiefe der Dotierung übersteigt. Durch die laterale Unterdiffusion verbleiben nach der Ätzung sowohl in einer linken Seitenwand in einem Bereich 15, als auch in der rechten Seitenwand in einem Bereich 25 ein Teil des implantierten Dotierstoffs. Bedingt durch die Implantation unter einem Tiltwinkel, weist der Bereich 25 in der rechten Seitenwand eine wesentlich höhere Dotierstoffkonzentration als der Bereich 15 in der linken Seitenwand auf. In einem nachfolgenden Prozeßschritt werden die Seitenwände durch einen Spacerprozeß, der eine Schutzschicht 35 aus Oxid erzeugt, vor der Einbringung eines weiteren Dotierstoffes geschützt. In einem nachfolgenden Prozessschritt wird mittels eines zweiten Implantationsschritts ein Dotierstoff, der zweiten Polarität, in den Bodenbereich der Grabenstruktur eingebracht, wobei durch einen nachfolgenden Diffusionsschritt der Dotierstoff in einen Bereich 42 eindiffundiert.

Das Querschnittsbild der Figur 2b zeigt eine Weiterentwicklung der in Figur 2a dargestellten grabenförmigen Struktur 8, wie sie beispielsweise zwischen zwei benachbarten Bauelementen oder innerhalb eines Bauelementes für hohe Spannungen, wie beispielsweise ein HVMOS-Transistor, einsetzen läßt. Im Folgenden werden die weiteren Prozeßschritte erläutert. Nach der Eindiffusion des Dotierstoffs in den Bereich 42, wird in einem nachfolgenden Prozessschritt mittels der Schutzschicht 35 eine anisotrope Siliziumätzung durchgeführt, deren Tiefe größer als die Eindringtiefe des Dotierstoffs ist. Durch eine begrenzte Selektiviät der Ätzrate von Silizium zu Oxid werden bei der Silizium-Ätzung die Seitenwände im Bodenbereich langsam zurückverlegt, wodurch sich ein Seitenwandbereich 9 und ein Seitenwandbereich. 11 ergibt. In einem nachfolgenden Prozessschritt wird das verbliebene Schutzoxid der Seitenwand entfernt und die grabenförmige Struktur 8 mittels einer nachfolgenden Implantation unter einem Tiltwinkel von ca. 30 Grad sowohl in den Bodenbereich und als auch in die linke Seitenwand ein Dotierstoff einer zweiten Polarität eingebracht, wobei die Dosis über der Dosis der zweiten Implantation liegt. In einem nachfolgenden Diffusionsschritt wird der Dotierstoff im Bodenbereich in einen Bereich 44 eindiffundiert. Ferner diffundiert während des Temperaturprozesses auch Dotierstoff aus dem Bereich 44 und dem Bereich 15 bzw. 25 in einen Bereich 17 bzw. 19 ein, wobei die Dotierstoffkonzentrationen in den Bereichen 17 bzw. 19 zwischen den Konzentrationen der Bereiche 15 und 44, bzw. 25 und 44 liegen. In einem nachfolgenden Prozessschritt wird die grabenförmige Struktur 8 mittels eines Oxids 60 aufgefüllt.

Durch die Möglichkeit auch bei geneigten Seitenwänden die Dotierstoffeinbringung der Seitenwände mittels Schutzschichten unabhängig von dem Bodenbereich einzustellen und in Verbindung mit der Möglichkeit auch die jeweiligen Seitenwänden unterschiedlich stark zu dotieren, läßt sich ausgehend von einer Seite der grabenförmigen Struktur 8 die Dotierstoffkonzentration kontinuierlich erhöhen. Damit läßt sich beispielsweise bei Anlegung einer Sperrspannung an die grabenförmige Struktur 8, durch Ableitung des Feldgradienten in eine vertikale Richtung, gegenüber einer ausschließlichen lateralen Ausbildung des Feldgradienten die benötigte Waferfläche reduzieren. Mittels Variation der Breite und Tiefe der grabenförmigen Struktur, läßt sich die Struktur leicht an die elektrischen Anforderungen anpassen. Ferner läßt sich das Verfahren auch auf Wafer mit einer isolierenden Zwischenschicht übertragen, indem die grabenförmige Struktur 8 in der oberen aktiven Siliziumschicht erzeugt wird, wobei die Dotierung und die Querschnittsfläche der unter der grabenförmigen Struktur 8 verbleibenden Siliziumschicht deren Stromtragfähigkeit bestimmt.

## Patentansprüche

1. Verfahren zur Ausbildung eines Silizium-Halbleiterkörpers (5), bei dem in einem ersten Prozessschritt mittels einer Dotierstoffmaske ein erster Dotierstoff eingebracht wird und hiernach in einem zweiten Prozessschritt wenigstens in einem Bereich der Maskenöffnung (7) mittels eines anisotropen Siliziumätzschritts eine grabenförmige Struktur (8) mit Seitenwänden (9, 11) erzeugt wird,
**dadurch gekennzeichnet, dass**
in einem dritten Prozessschritt ein zweiter Dotierstoff derart eingebracht wird, dass die Dotierstoffkonzentration (15, 25, 17, 19) in den Seitenwänden (9, 11) der grabenförmigen Struktur (8) unterschiedlich ist.

2. Verfahren nach Anspruch 1,
**dadurch gekennzeichnet, dass**
vor oder nach dem zweiten Prozessschritt eine Diffusion des ersten Dotierstoffs durchgeführt wird.

3. Verfahren nach einem der Ansprüche 1 oder 2,
**dadurch gekennzeichnet, dass**
im dritten Prozessschritt der zweite Dotierstoff räumlich selektiv eingebracht wird.

4. Verfahren nach einem der Ansprüche 1 oder 2,
**dadurch gekennzeichnet, dass**
vor dem Einbringen des Dotierstoff wenigstens eine Seitenwand der grabenförmigen Struktur (8) mit einer Schutzschicht belegt wird.

5. Verfahren nach Anspruch 4,
**dadurch gekennzeichnet, dass**
alle Seitenwände mit einer Schutzschicht (30, 35) belegt werden.

6. Verfahren nach einem der Ansprüche 4 oder 5,
**dadurch gekennzeichnet, dass**
als Schutzschicht (30, 35) ein Siliziumdioxid erzeugt wird.

7. Verfahren nach einem der Ansprüche 4 bis 6,
**dadurch gekennzeichnet, dass**
die Schutzschicht (30, 35) selbstjustierend erzeugt wird.

8. Verfahren nach einem der vorhergehenden Ansprüche,
**dadurch gekennzeichnet, dass**
der erste und der zweite Dotierstoff mittels einer Implantation eingebracht wird und vorzugsweise einen zu der Oberfläche des Halbleiterkörpers senkrechten Implantationswinkel aufweist.

9. Verfahren nach Anspruch 8,
**dadurch gekennzeichnet, dass**
die Dotierstoffe im ersten und dritten Prozessschritt von gleicher Polarität jedoch mit einer unterschiedlichen Dosis implantiert werden.

10. Verfahren nach Anspruch 9,
**dadurch gekennzeichnet, dass**
die Implantation im dritten Prozessschritt mit einer größeren Dosis als im ersten Prozessschritt durchgeführt wird.

11. Verfahren nach Anspruch 10,
**dadurch gekennzeichnet, dass**
die Implantation in zwei Schritten durchgeführt wird, wobei im ersten Schritt der erste Dotierstoff unter einem senkrechten Implantationswinkel eingebracht wird.

12. Verfahren nach Anspruch 6,
**dadurch gekennzeichnet, dass**
die Dotierstoffe des ersten Prozessschrittes und des dritten Prozessschrittes von unterschiedlicher Polarität sind.

13. Verfahren nach einem der vorhergehenden Ansprüche,
**dadurch gekennzeichnet, dass**
das Verhältnis von Grabenbreite zu Grabentiefe größer als 0.5 ist.

14. Verfahren nach einem der vorhergehenden Ansprüche,
**dadurch gekennzeichnet, dass**
vor dem dritten Prozessschritt ein weiterer anisotroper Siliziumätzschritt unter Verwendung der Schutzschicht als Ätzmaske durchgeführt wird.

15. Verfahren nach einem der vorhergehenden Ansprüche,
**dadurch gekennzeichnet, dass**
nach dem zweiten Prozessschritt wenigstens einer der Prozessschritte eins bis drei mehrfach durchgeführt wird.

16. Verwendung des Verfahrens nach einem der vorhergehenden Ansprüche zur Erzeugung eines HVMOS-Transistors.

## Claims

1. Method of constructing a silicon semiconductor body (5), in which in a first process step a first doping material is introduced by means of a doping material mask and thereafter in a second process step a trench-shaped structure (8) with side walls (9, 11) is produced at least in a region of the mask opening (7) by means of an anisotropic silicon etching step, **characterised in that** in a third process step a second doping material is introduced in such a manner that the doping material concentration (15, 25, 17, 19) in the side walls (9,11) of the trench-shaped structure (8) is different.

2. Method according to claim 1, **characterised in that** before or after the second process step a diffusion of the first doping material is carried out.

3. Method according to one of claims 1 and 2, **characterised in that** in the third process step the second doping material is selectively introduced three-dimensionally.

4. Method according to one of claims 1 and 2, **characterised in that** before introduction of the doping material at least one side wall of the trench-shaped structure (8) is coated with a protective layer.

5. Method according to claim 4, **characterised in that** all side walls are coated with a protective layer (30, 35).

6. Method according to one of claims 4 and 5, **characterised in that** a silicon dioxide is produced as protective layer (30, 35).

7. Method according to one of claims 4 to 6, **characterised in that** the protective layer (30, 35) is produced in self-adjusting manner.

8. Method according to one of the preceding claims, **characterised in that** the first and the second doping material are introduced by means of an implantation and preferably have an implantation angle perpendicular to the surface of the semiconductor body.

9. Method according to claim 8, **characterised in that** the doping materials in the first and third process step are of the same polarity, but are implanted with a different dose.

10. Method according to claim 9, **characterised in that** the implantation in the third process step is carried out with a greater dose than in the first process step.

11. Method according to claim 10, **characterised in that** the implantation is carried out in two steps, wherein in the first step the first doping material is introduced at a perpendicular implantation angle.

12. Method according to claim 6, **characterised in that** the doping materials of the first process step and the third process step are of different polarity.

13. Method according to one of the preceding claims, **characterised in that** the ratio of trench width to trench width is greater than 0.5.

14. Method according to one of the preceding claims, **characterised in that** prior to the third process step a further anisotropic silicon etching step is carried out with use of the protective layer as etching mask.

15. Method according to one of the preceding claims, **characterised in that** after the second process step at least one of the process steps is carried out once to three times in repetition.

16. Use of the method according to one of the preceding claims for producing an HVMOS transistor.

## Revendications

1. Procédé de fabrication d'un corps de semi-conducteur (5) en silicium, dans lequel dans une première étape on introduit un premier dopant au moyen d'un masque à dopant et ensuite dans une deuxième étape on produit au moins dans une zone de l'ouverture de masque (7) une structure (8) en forme de tranchée présentant des parois latérales (9, 11) au moyen d'une étape de corrosion du silicium anisotrope, **caractérisé en ce que** dans une troisième étape on introduit un deuxième dopant de telle façon que la concentration en dopant (15, 25, 17, 19) dans les parois latérales (9, 11) de la structure (8) en forme de tranchée soit différente.

2. Procédé selon la revendication 1, **caractérisé en ce qu'**avant ou après la deuxième étape on effectue une diffusion du premier dopant.

3. Procédé selon l'une quelconque des revendications 1 ou 2, **caractérisé en ce que** durant la troisième étape on introduit le deuxième dopant de manière sélective du point de vue de l'emplacement.

4. Procédé selon l'une quelconque des revendications 1 ou 2, **caractérisé en ce qu'**avant l'introduction du dopant, on recouvre d'une couche protectrice au moins une paroi latérale de la structure (8) en forme de tranchée.

5. Procédé selon la revendication 4, **caractérisé en ce que** l'on recouvre toutes les parois latérales d'une couche protectrice (30, 35).

6. Procédé selon l'une quelconque des revendications 4 ou 5, **caractérisé en ce que** l'on forme un dioxyde de silicium comme couche protectrice (30, 35).

7. Procédé selon l'une quelconque des revendications 4 à 6, **caractérisé en ce que** la couche protectrice (30, 35) est formée par auto-ajustage.

8. Procédé selon l'une quelconque des revendications précédentes, **caractérisé en ce que** les premier et deuxième dopants sont introduits au moyen d'une implantation et selon une direction d'implantation perpendiculaire à la surface du corps de semi-conducteur.

9. Procédé selon la revendication 8, **caractérisé en ce que** les dopants sont implantés durant la première et la troisième étape selon une polarité identique mais à des doses différentes.

10. Procédé selon la revendication 9, **caractérisé en ce que** durant la troisième étape, l'implantation est effectuée à une dose supérieure à celle de la première étape.

11. Procédé selon la revendication 10, **caractérisé en ce que** l'implantation est effectuée en deux étapes, le premier dopant étant introduit durant la première étape sous un angle droit d'implantation.

12. Procédé selon la revendication 6, **caractérisé en ce que** les dopants de la première étape et de la troisième étape sont de polarité différente.

13. Procédé selon l'une quelconque des revendications précédentes, **caractérisé en ce que** le rapport entre la largeur de la tranchée et sa profondeur est supérieur à 0,5.

14. Procédé selon l'une quelconque des revendications précédentes, **caractérisé en ce que** durant la troisième étape on effectue une étape de corrosion du silicium anisotrope supplémentaire en utilisant la couche de protection comme masque de corrosion.

15. Procédé selon l'une quelconque des revendications précédentes, **caractérisé en ce qu'**après la deuxième étape, on effectue à plusieurs reprises au moins l'une des étapes de une à trois.

16. Utilisation du procédé selon l'une quelconque des revendications précédentes pour fabriquer un transistor HVMOS.
